# EUROPEAN PATENT APPLICATION

(11) **EP 0 537 733 A2**
(43) Date of publication of application: **21.04.1993**
(21) Application number: 92117617.8
(22) Date of filing: 15.10.1992
(51) Int. Cl.: H03G 3/20, H03F 1/02, H03G 1/04, H04B 7/005

(54) **Satellite amplifier control device**

(30) Priority: 16.10.1991 IT MI912726
(71) Applicant: FIAR FABBRICA ITALIANA APPARECCHIATURE RADIOELETTRICHE S.p.A., I-20157 Milano (IT)
(72) Inventor: Denti, Ferruccio, I-20100 Milan (IT); Battisti, Alberto, I-20100 Milan (IT)
(74) Representative: Modiano, Guido, Dr.-Ing.

(57) **Abstract**

A control device for amplifiers in satellites comprises digital compensation means (11), which receive in input a signal from temperature control means (10) and generate a phase compensation signal sent to an amplifier (1); and analog compensation means (12), supplied with a signal proportional to the input power to the amplifier (1) and generating an analog signal to be added to the phase compensation signal, the sum of the two signals being input to means (14) for comparison with a reference threshold. The comparison means (14) generate an attenuation or loss compensation signal supplied to the amplifier (1), conversion means (16) being furthermore provided receiving in input a power supply and the analog signal to generate a compensated power supply signal for the amplifier (1).

## Description

The present invention relates to a control device particularly for amplifiers in satellites and the like.

As is known, most payloads installed in satellite shells are constituted by telecommunications systems.

Currently there is an enormous demand for telecommunications satellites use which is saturating the capacities of every telecommunications satellite. A solution which meets this requirement is to increase the number of this kind of payload in order to increase the capacity of each satellite. This need, as is evident, clashes with the need to raise into earth orbit the smallest possible load in order to reduce the costs related to the launching and orbiting of a satellite.

Said need also clashes with the need of each individual component of a payload. In particular, there are heavy restrictions and problems regarding amplifiers, which practically constitute the core of each telecommunications-related payload.

Amplifiers must work over a wide range of temperatures and input power levels, and must have high output power, high efficiency and linearity and gain and phase similarities. These characteristics are already normally very difficult to achieve individually, and it is thus particularly difficult to meet them in cases, such as the present one, in which they are required simultaneously.

In the literature there are examples of individual optimization for each one of the above described requirements, but an overall solution to the problem of simultaneous optimization is lacking, especially due to the technical difficulties posed by the described problem.

The aim of the present invention is to eliminate or substantially reduce the problems described above by providing a control device particularly for amplifiers in satellites and the like which simultaneously optimizes the requirements of high output power, high efficiency and linearity and similarity in gain and phase with a wide temperature and input power range.

Within the scope of the above aim, an object of the present invention is to provide a control device which can be qualified, i.e. which passes the tests prescribed for space payloads, with a temperature range equal to, or greater than, 100^{o}C.

Not least object of the present invention is to provide a control device which is highly reliable, relatively easy to manufacture and at competitive costs.

This aim, the objects mentioned and others which will become apparent hereinafter are achieved by a control device particularly for amplifiers in satellites and the like according to the invention, as defined in the accompanying claims.

Further characteristics and advantages of the invention will become apparent from the description of a preferred but not exclusive embodiment of a control device particularly for amplifiers in satellites and the like according to the invention, illustrated only by way of non-limitative example in the accompanying drawings, wherein:
figure 1 is a block diagram of a device according to the invention in which the several signals are specifically indicated by numeral references marking the respective signal lines whereon said signals are transmitted; and
figure 2 plots the characteristic curves of input power versus output power and input power versus amplifier supply voltage achieved by the device according to the invention.

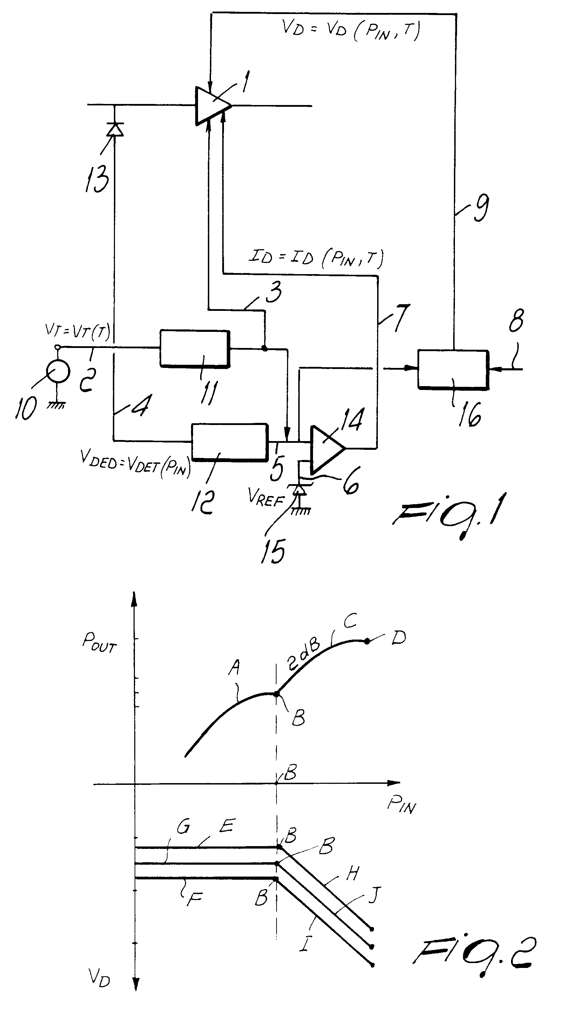

With reference to figure 1, a control device particularly for amplifiers in satellites and the like comprises: digital compensation means 11 which receive in input a signal 2 which arrives from temperature control means 10 to generate a phase compensation signal 3 which is input to an amplifier 1; and analog compensation means 12 which receive in input a signal 4 which is proportional to the power input to the amplifier 1 to generate an analog signal 5 which can be added to the phase compensation signal 3 which is input to means 14 for comparison with a reference threshold 6.

The comparison means generate an attenuation compensation signal 7 which is input to the amplifier 1. Conversion means 16 are furthermore provided which receive in input a power supply 8 and the sum signal of the signals 5 and 8 to generate a compensated power supply signal 9 for the amplifier 1.

The temperature detection means comprise at least one temperature sensor 10, such as for example a thermistor, which generates the signal 2, i.e. a voltage, designated by the same reference numeral 2, which represents the detected temperature.

The digital compensation means 11 receive in input the voltage 2 and convert it into the phase compensation signal 3, constituted by a phase compensation voltage which is a function of the temperature, is designated by the same reference numeral and is input to the amplifier 1.

The signal 4 which is proportional to the power is constituted by a voltage, designated by the same reference numeral, which is proportional to the power input to the amplifier, which is detected by means of at least one first diode 13.

The analog compensation means 12 generate, starting from said voltage 4, the analog signal 3, constituted by a voltage 3, which is added to the phase compensation voltage 3 generated by the digital compensation means 11.

The comparison means comprise a comparator 14 which compares the sum voltage of the voltages 3 and 5 with the reference threshold 6, which is constituted by a reference voltage, designated by the same reference numeral, supplied by at least one second ground-connected diode 15 to generate the attenuation compensation signal 7 as a function of the input power and of the temperature; said signal 7 is constituted by a loss compensation current, designated by the same reference numeral, which is input to the amplifier 1.

The conversion means comprise a direct-current converter 16 which receives in input the power supply 8 and the sum voltage of the voltages 3 and 5 to generate the compensated power supply signal 9, constituted by a supply voltage which is input power-compensated and temperature-compensated and is designated by the same reference numeral, of the amplifier 1.

Advantageously, the device according to the invention allows to operate not in the linear region but at a preset compression, for example equal to 2 dB's, as shown in the upper diagram of figure 2. In fact (see curve A of figure 2), initially the amplifier 1 operates along this curve until a compression of 2 dB's is reached (point B), then as the input power increases it follows the curve C which connects points B and D. From the point of view of the power supply of the amplifier 1 (see the lower part of figure 2, which plots input power versus amplifier supply voltage), the supply voltage, represented by the segment G, remains confined within a narrow interval delimited by segments E and F until the input power remains below point B. When the input power exceeds this point, the power supply voltage, segment H, is increased by an amount which is equal to the sum of the voltages 3 and 5 and remains in any case confined within a range delimited by segments I and J.

Curve C is the relation of output power as a function of input power at a constant compression which, in the case of figure 2, has been chosen equal to 2 dB's but can be selected according to the particular applications or to the particular technical response specifications required.

The invention thus conceived is susceptible to numerous modifications and variations, all of which are within the scope of the inventive concept. All the details may furthermore be replaced with other technically equivalent elements.

In practice, the materials employed, as well as the dimensions, may be any according to the requirements.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. A control device particularly for amplifiers in satellites and the like, characterized in that it comprises: digital compensation means (11), which receive in input a signal from temperature control means (10) to generate a phase compensation signal sent to an amplifier (1); and analog compensation means (12), receiving in input a signal proportional to the input power to said amplifier (1) to generate an analog signal to be added to said phase compensation signal and input to means (14) for comparison with a reference threshold; said comparison means (14) generating an attenuation compensation signal input to said amplifier (1), conversion means (16) being moreover provided receiving in input a power supply signal and said analog signal to generate a compensated power supply for said amplifier (1).

2. A device according to claim 1, characterized in that said temperature detection means (10) comprise at least one temperature sensor (10) generating a voltage representing a detected temperature.

3. A device according to the preceding claims, characterized in that said digital compensation means (11) receive in input said temperature-representing voltage to convert it into said phase compensation signal comprising a phase compensation voltage input to said amplifier (1).

4. A device according to one or more of the preceding claims, characterized in that said analog compensation means (12) generate, starting from said power-proportional voltage, said analog signal, comprising an analog voltage and is added to said phase compensation voltage generated by said digital compensation means (11).

5. A device according to one or more of the preceding claims, characterized in that said conversion means (16) comprise a dc converter (16) which receives in input a power supply signal and said analog voltage to generate a temperature and input power compensated supply voltage for said amplifier (1).
